# EUROPEAN PATENT APPLICATION

(11) **EP 4 387 094 A1**
(43) Date of publication of application: **19.06.2024**
(21) Application number: 23211435.5
(22) Date of filing: 22.11.2023
(51) Int. Cl.: H03F 3/45, H03F 1/02, H03F 3/08, H03F 3/14, G05F 1/46

(54) **DC VOLTAGE REGULATION AND TIA WITH INPUT-OUTPUT DC VOLTAGE CONTROL**

(30) Priority: 12.12.2022 US 202263431928 P
(71) Applicant: Nokia Solutions and Networks Oy, 02610 Espoo (FI)
(72) Inventor: FERRISS, Mark, Tarrytown - NY 10591 (US); IOTTI, Lorenzo, Brooklyn - NY 11211 (US); RYLYAKOV, Alexander, Staten Island - NY 10312 (US)
(74) Representative: Nokia EPO representatives

(57) **Abstract**

An apparatus, such as a coherent optical receiver, includes a trans-impedance amplifier, TIA, (410) and a low dropout, LDO, voltage regulator circuit for providing a supply voltage (VCC_{REG}) to the TIA (410). The LDO circuit is configured to adjust the supply voltage responsive to a DC voltage (V_{CMOUT}) at an output of the TIA (410). In some implementations the LDO circuit may provide only a fraction of a supply current to the TIA (410), with another fraction provided by a partial current replica source.

## Description

### FIELD

Various example embodiments relate to electrical circuits and methods for voltage regulators, trans-impedance amplifiers, and optical receivers using such voltage regulators and trans-impedance amplifiers.

### BACKGROUND

Trans-impedance amplifiers (TIAs) are used in high speed fiber optic communication systems. TIAs provide a link between the optical-to-electrical photodetectors (PDs), and the downstream electronics. A TIA converts a current coming from the PDs into a voltage, thus providing transimpedance gain (ZT). This voltage is typically fed to an ADC, and the resulting signal may be processed in the digital domain. The TIA is desirably linear and has a well-controlled gain, in the relevant operating range, so that the ADC receives a voltage that is a linear representation of the current from the PDs and has a magnitude that matches the dynamic range of the ADC.

### SUMMARY

An example embodiment of the present disclosure provides an apparatus comprising a TIA and an LDO circuit for providing a supply voltage to the TIA. The LDO circuit is configured to adjust the supply voltage responsive to a DC voltage at an output of the TIA.

In some embodiments of the above apparatus, the LDO circuit is configured to adjust the supply voltage to lessen variations of the DC voltage at an output of the TIA.

In some embodiments of the above apparatus, the LDO circuit is configured to control a common-mode DC output voltage of the TIA.

In any of the above embodiments, the LDO circuit may comprise an operational amplifier configured to adjust the supply voltage to change the DC voltage at an output of the TIA towards a reference voltage. Some embodiments may further comprise an input DC current cancellation circuit configured to adjust a DC input voltage of the TIA towards the reference voltage. In some of such above embodiments, the output of the TIA may be configured to provide a differential output signal, and the DC voltage at an output of the TIA may be a common-mode DC voltage at the output of the TIA. In some of such embodiments, the DC input voltage of the TIA is a common-mode DC voltage at the input of the TIA.

In any of the above embodiments, the LDO circuit may be configured to regulate less than 50% of a supply DC current of the TIA.

In any of the above embodiments, the LDO circuit may be configured to regulate a first portion of a supply DC current of the TIA, with the apparatus further comprising a current mirror for adding a second portion of the supply DC current to the first portion at a supply voltage node of the TIA. In some embodiments the first portion is less than 50% of the supply DC current of the TIA. In some embodiments, the apparatus further comprises a source of reference current coupled to an input of the current mirror.

Some of the above embodiments may include a coherent optical receiver. The coherent optical receiver may comprise an optical hybrid and photodiodes to receive light from corresponding outputs of the optical hybrid. The coherent optical receiver may comprise the TIA and the LDO circuit, with first and second of the photodiodes being connected to corresponding inputs of the TIA. In any of the above embodiments, the LDO circuit may be configured to provide a common-mode feedback from the output of the TIA to regulate the supply voltage.

A second example embodiment disclosed herein provides an apparatus comprising: a voltage regulating circuit for providing a regulated voltage to a node of the circuit, wherein a load is connected to the node. The voltage regulating circuit comprises a low-dropout voltage regulator (LDO) connected to provide a first portion of a load current to the node, and a second circuit connected to provide a second portion of the load current to the node. In some embodiments of the apparatus of the second example, the second portion is at least half of the load current.

In any of the above embodiments of the second example, the second circuit may comprise a reference current source and a current mirror coupling the reference current source to the node. The current mirror is configured to output the second portion of the load current. In any of the above embodiments of the second example, the apparatus may further comprise a TIA having a supply voltage terminal connected to the node. In any of the above embodiments of the second example, the LDO may be configured to adjust the regulated voltage responsive to deviations of an output DC voltage of the TIA from a reference DC voltage.

Any of the above embodiments of the second example may comprise a coherent optical receiver including the TIA and the voltage regulating circuit. The LDO may be configured to provide a common-mode feedback from the output of the TIA to regulate the supply voltage.

An aspect of the present disclosure provides a method comprising: providing a supply voltage to a trans-impedance amplifier (TIA) using a low drop-out (LDO) circuit; and configuring the LDO circuit to adjust the supply voltage responsive to a DC voltage at an output of the TIA.

Some embodiments of the method may comprise the LDO adjusting the supply voltage toward a reference voltage to lessen variations of the DC voltage at the output of the TIA.

### BRIEF DESCRIPTION OF THE DRAWINGS

Embodiments disclosed herein will be described in greater detail with reference to the accompanying drawings which represent preferred embodiments thereof, in which like elements are indicated with like reference numerals, and wherein:
FIG. 1 is a schematic block diagram of a coherent optical receiver using the TIA(s) of the present disclosure may be used;
FIG. 2 is a schematic block diagram of a TIA circuit that may be used in the coherent optical receiver of FIG. 1;
FIG. 3 is a circuit diagram of a shunt-feedback front-end TIA with a closed-loop input DC bias circuit;
FIG. 4 is a circuit diagram of an example front-end TIA with an LDO;
FIG. 5 is a circuit diagram of a front-end TIA with an LDO bias according to an embodiment of the present disclosure;
FIG. 6 is a circuit diagram of an embodiment of the front-end TIA of FIG. 5 with an input DC voltage cancellation using an LDO-shared voltage reference;
FIG. 7 is a circuit diagram of a typical LDO;
FIG. 8 is a circuit diagram of an LDO circuit according to an embodiment of the present disclosure.
FIG. 9 is a circuit diagram of a front-end TIA powered by an embodiment of the LDO circuit of FIG. 8.

### DESCRIPTION

In the following description, for purposes of explanation and not limitation, specific details are set forth, such as particular circuits, circuit components, techniques, etc. in order to provide a thorough understanding of the present invention. However, it will be apparent to one skilled in the art that the present invention may be practiced in other embodiments that depart from these specific details. In other instances, detailed descriptions of well-known methods, devices, and circuits may be omitted so as not to obscure the description of the present invention. All statements herein reciting principles, aspects, and embodiments of the invention, as well as specific examples thereof, are intended to encompass both structural and functional equivalents thereof. Additionally, it is intended that such equivalents include both currently known equivalents as well as equivalents developed in the future.

Furthermore, the following abbreviations and acronyms may be used in the present document:
ADC: Analog to Digital Converter
AGC: Automatic Gain Control
AV: voltage gain
BW: Bandwidth
CMFB: Common Mode FeedBack
DSP: Digital Signal Processor
FET: Field-Effect Transistor
LDO: Low DropOut regulator
LNA: Low Noise Amplifier
MOS: Metal-Oxide-Semiconductor
OpAmp: Operational Amplifier
PSRR: Power Supply Rejection Ratio
PVT: Process/supply Voltage/Temperature
SNR: Signal to Noise Ratio
TIA: TransImpedance Amplifier
ZT: transimpedance
VDS: drain-source voltage drop

### TIA

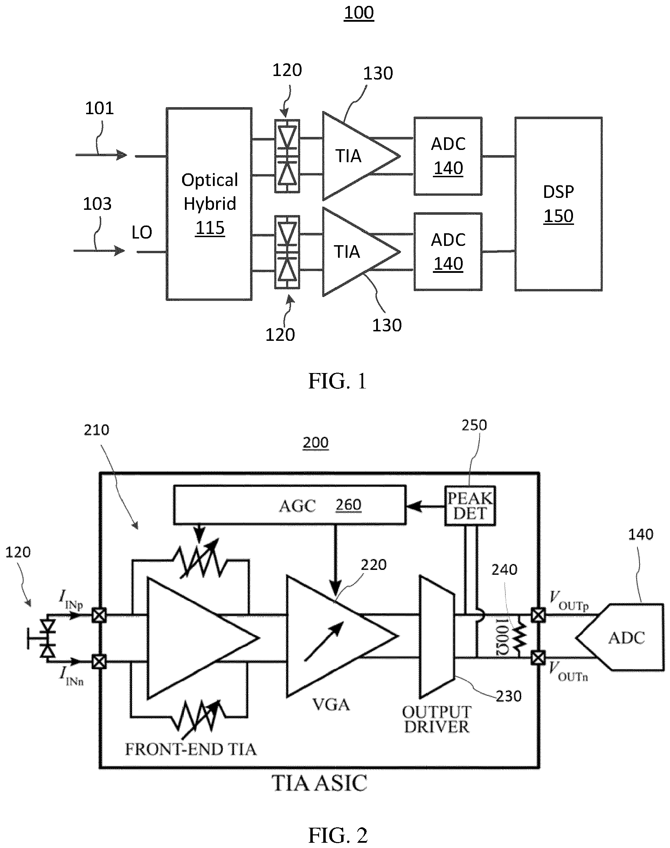

FIG. 1 illustrates a block diagram of an example coherent optical receiver 100 to which embodiments of the present disclosure may relate. An optical signal 101 received from an optical communication link (not shown) is mixed with local oscillator (LO) light 103 in an optical hybrid 115. Different mixtures of the optical signal 101 and LO light 103 from four output ports of the optical hybrid 115 are transmitted to two photodiode (PD) pairs 120. Each PD pair 120 may be suitably biased at mid-point. The two PDs of a pair measure mixtures of the received optical signal light with LO light with different relative phase shifts. The signals from the two PDs of a pair are coupled to the differential inputs of a corresponding TIA 130. Differential outputs of the TIAs are provided to respective ADCs 140, which are, in turn, connected to a DSP 150 for signal processing and data demodulation.

A block diagram of a typical TIA circuit 200, which may be implemented e.g. as an Application-Specific Integrated Circuit (ASIC), is shown in FIG. 2. It includes a front-end TIA (FE-TIA) 210, which converts PD current(s), e.g. *I*_{INp}, *I*_{Inn} from a PD pair 120, into a voltage signal, followed by a series of one or more Variable Gain Amplifiers (VGA) 220 to provide further voltage amplification, and an output driver 230. The output driver 230 is typically a transconductor, which drives an on-chip termination resistor 240 as well as being connected to the inputs of the ADC 140. The TIA circuit 200 may also include a peak detector 250 to measure the output swing, and an Automatic Gain Control (AGC) loop 260, which adjusts the TIA gain in order to keep the peak output swing at a desired value in the presence of slow variations of the swing of the currents *I*_{INp}, *I*_{INn} input to the TIA.

For the coherent optical receiver illustrated in FIG. 1, the TIA input signal amplitude can vary suddenly by >10x (20dB) due to events in the optical network. Such events can substantially change the optical signal propagating to an optical receiver, at a rate much lower than the baud rate or symbol rate of the optical signal. In response to such events, gain of the TIA circuit may be adjusted by the AGC 260, so that the amplitude of the output signal, e.g. a differential output voltage Δ*V*_{OUT} = (*V*_{OUTp}-*V*_{OUTn}), remains about constant and remains within a desirable operating range of the ADC 140 connected to receive the output signals of the TIA circuit 200.

The DC voltage bias of internal nodes of a FE-TIA should preferably be kept at a desired value, which should not vary significantly with PVT (process, voltage, and temperature) variations, and variations of the TIA gain and/or variations of the input DC and AC signals.

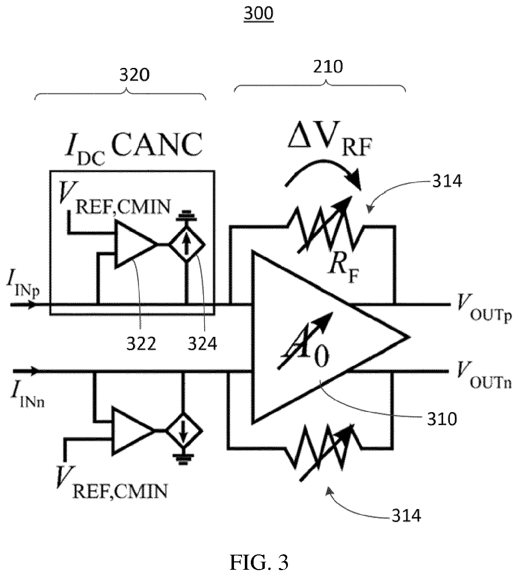

FIG. 3 schematically illustrates an example TIA circuit 300 including the FE-TIA 210 having a shunt-feedback topology. In this topology, which is typically used, e.g., for high-speed, low-noise applications, the transimpedance (ZT) of the FE-TIA 210 is typically varied by varying the value R_{F} of feedback resistor(s) 314. The feedback resistor(s) 314 may be a circuit having tunable resistance and one or more elements. Each of the feedback resistor 314 typically includes a voltage-controlled MOS transistor (not shown in FIG. 3) operated in the triode regime. One challenge is that the current versus voltage (I-V) characteristic of resistors implemented with triode MOS transistors typically becomes highly nonlinear when the drain-source voltage drop (V_{DS}) is not suitably close to 0 volts. Therefore, it may be desirable that the two terminals of the variable resistor 314 are kept at approximately the same DC level, i.e. the voltage drop ΔV_{RF} across the resistor(s) 314 should be substantially zero, or at least the voltage drop ΔV_{RF} should preferably be small enough so that the MOS transistor in the feedback resistor 314 is in its substantially linear regime of operation.

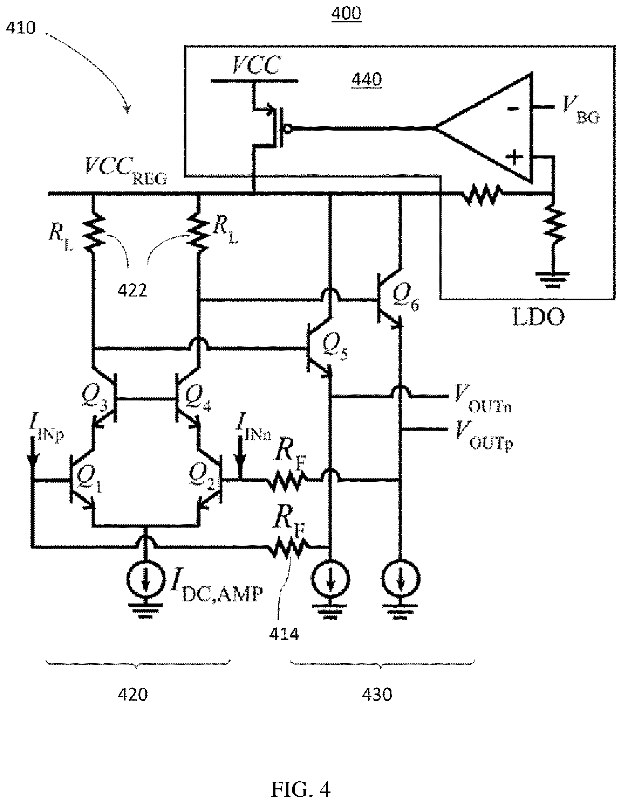

One aspect of the present disclosure relates to a closed-loop technique for reducing the voltage drop ΔV_{RF} across the TIA feedback resistor 314. In the following, the FE-TIA, such as the FE-TIA 300 that is illustrated in FIG. 3 and that is typically followed by a VGA in a TIA circuit, e.g. as illustrated in FIG. 2, will be referred simply as the TIA. FIGs. 4 - 6 and 9 illustrate examples of such FE-TIAs ("TIAs") according to the present disclosure.

In coherent optical applications, the DC current entering the TIA 210 can reach values of a few milli-amperes (mA) and vary significantly over time. A closed-loop input DC current cancellation circuit (IDC CANC), such as e.g. the IDC CANC 320 shown in FIG. 3, is typically employed to absorb this current so that the TIA's input DC bias is maintained approximately at a desired reference value. The IDC CANC 320 includes an operational amplifier 322 driving a voltage-controlled current source 324, e.g. a bipolar or FET transistor, connected in a negative feedback loop to reduce the difference between the TIA input DC voltage and a reference voltage V_{REF,CMIN}. Due to this circuit, the input terminal of the feedback resistor(s) 314 is set to a controlled DC voltage approximately equal to the reference voltage V_{REF,CMIN}. The reference voltage V_{REF,CMIN} is generated e.g. from an approximately PVT-independent reference circuit, such as the well-known "bandgap reference" (not shown in FIG. 3). As a result, the TIA input DC voltage is well controlled and stable in the presence of voltage, supply and process variations.

On the other hand, the DC voltage of the output terminal of the variable resistor (circuit) 314 is set by the voltage amplifier 310 of the TIA ("core amplifier 310", shown as a gain stage with a gain A₀ in FIG. 3). This DC voltage is a function of supply variations and process and temperature variations of resistors, bias currents, and of threshold voltages inside the core amplifier 310. As a result, the DC voltage drop ΔV_{RF} across the feedback resistor 314 can vary significantly, thereby reducing the TIA's linearity.

FIG. 4 shows an example diagram of a typical TIA circuit 400 with a low-dropout regulator (LDO) 440 connected to a supply voltage VCC to provide a regulated supply voltage VCC_{REG} to a TIA 410 with shunt-feedback resistor(s) 414 having resistance R_{F}. The LDO 440 operates to reduce supply noise and to improve accuracy of the amplifier supply voltage, and therefore of the output DC bias. However, the output DC bias of the TIA still may vary due to process and temperature variations of other amplifier components.

For example, in the TIA circuit 400 of FIG. 4, the output DC common-mode voltage V_{CMOUT} is given approximately by (VCC_{REG} - I_{DC,AMP}*R_{L} - V_{be,Q5/Q6}). Here I_{DC,AMP} is the tail DC current of an input stage 420 of the TIA 410, R_{L} is the resistance of load resistors 422 of the input stage 420, V_{be,Q5/Q6} is the base - emitter voltage of transistors Q₅ and Q₆ of an emitter follower 430 the TIA 410. The value of the output DC common-mode voltage V_{CMOUT} is therefore a function of regulated supply VCC_{REG}, DC current I_{DC,AMP} and the load resistance R_{L} (which vary with process and temperature), and is also a function of the base-emitter voltages V_{be,Q5/Q6} of the bipolar transistors Q₅ and Q₆, which may have a strong temperature dependency.

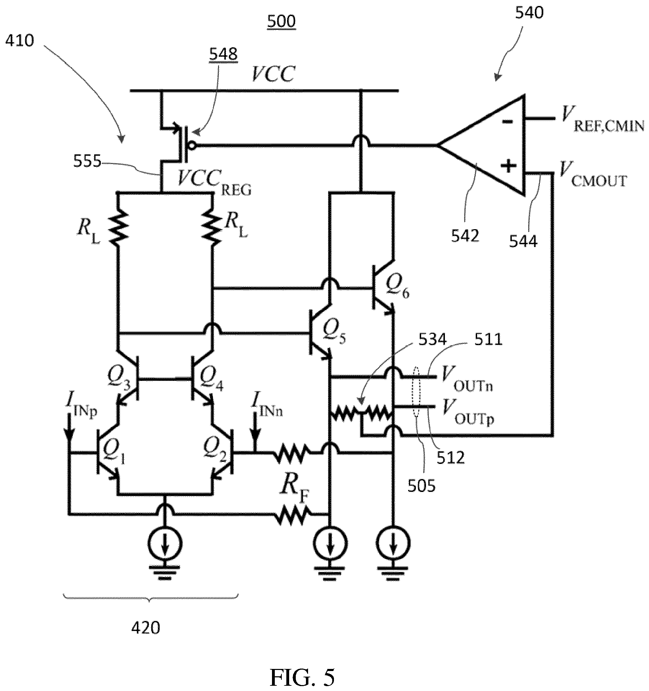

An example TIA circuit 500 of the present disclosure is shown in FIG. 5. In the illustrated circuit, an LDO 540 includes an operational amplifier (OpAmp) 542 with two inputs and one output. The output of the LDO 540 connects to a gate of a FET 548 to control the regulated supply voltage VCC_{REG} 555 to the TIA. One of the OpAmp's inputs is connected to sense the DC common-mode component of the output voltage of a TIA 410 instead of sensing the amplifier supply voltage VCC as in the TIA-LDO configuration ("TIA circuit 400") shown in FIG. 4. In the TIA circuit 500 of FIG. 5, the voltage-sensing input terminal 544 of the LDO 540, i.e. one of the input terminals of the OpAmp 542, is connected to a common-mode node 534 of a differential output 505 of the TIA 410. An output common-mode (DC) voltage V_{CMOUT} is an average between voltages at the positive (512) and negative (511) output terminals of the TIA 410, and can be measured, e.g., at a node electrically connected to the positive and negative TIA outputs by resistors of a same value, e.g. node 534. In this embodiment, the LDO 540 operates by comparing a common-mode output voltage V_{CMOUT} of the TIA 410 against a voltage reference V_{REF,CMIN}. The LDO 540 adjusts the regulated supply voltage VCC_{REG} 555 to reduce the magnitude of the difference |V_{CMOUT}- V_{REF,CMIN}|. Therefore, the LDO 540 acts as a common-mode feedback loop (CMFB) for the TIA 410.

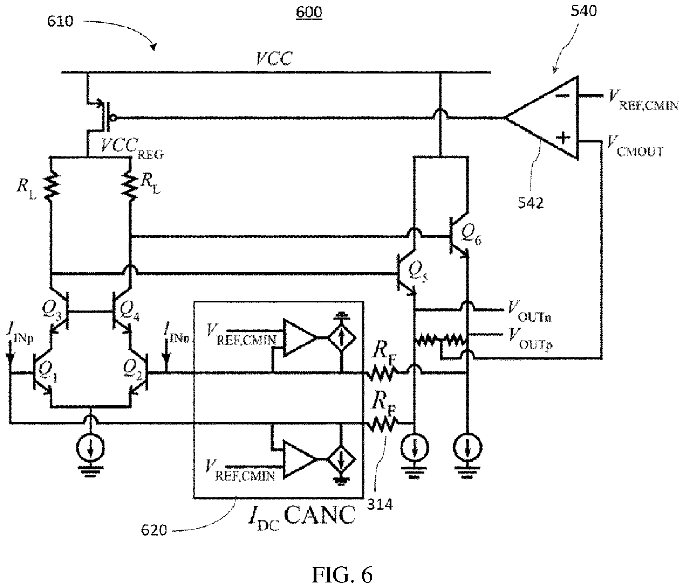

FIG. 6 illustrates an embodiment 600 of the TIA circuit 500 of FIG. 5 ("TIA circuit 600") including input DC cancellation circuit(s) 620, labeled "I_{DC} CANC", e.g., as described above with reference to IDC CANC 320 shown in FIG. 3. In some embodiments the same voltage reference V_{REF,CMIN} may be used to set both the amplifier input common-mode voltage V_{CMIN}, e.g. using the IDC CANC circuit 620, i.e, circuit 320 shown in FIG. 3, and the common-mode output voltage V_{CMOUT}. Since the inputs and outputs of a core amplifier 610 of the TIA 600 are connected to the two terminals of the feedback resistors 314, setting the input and output common-mode of the TIA 600 to approximately the same voltage may have the advantage of reducing the DC voltage drop across the feedback resistors 314 and may thereby improve the linearity of the variable feedback resistors 314.

The circuits of FIGs. 5 and 6 operate to keep both the TIA input and output DC bias at a same reference value using a closed-loop control. If the loop gain of the feedback circuit implemented with the LDO 540 is sufficiently large, the DC bias may be substantially independent of PVT and TIA ZT variations.

Since typical TIAs incorporate an LDO to provide low-noise supply to the amplifier, the technique illustrated in FIGs. 5 and 6 adds little complexity and power overhead compared to the scheme shown in FIG. 4.

An LDO used in the example closed-loop circuits of FIGs. 5 and 6, such as e.g. the LDO 540, should preferably be operable to set the VCC_{REG} with sufficient precision, to provide significant current to supply an input stage 420 of the TIA 410 (typically 10mA or more), and to provide low-noise operation and high power-supply rejection ratio (PSRR) across the 3dB bandwidth (BW) of the TIA. Below an example LDO circuit is described that may be capable of meeting at least some of these expectations.

### LDO

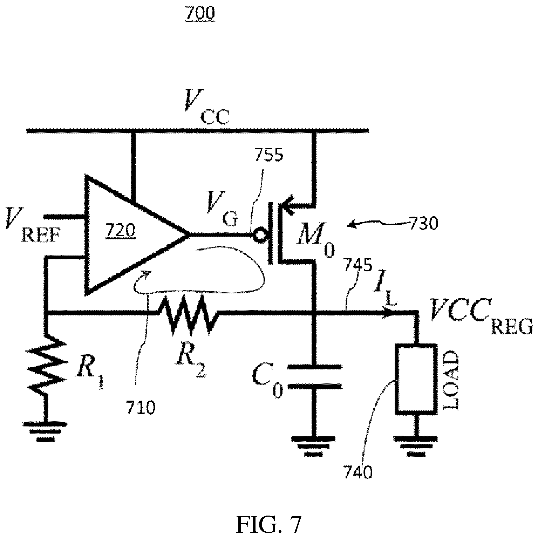

Referring to FIG. 7, a typical LDO 700 is based on a feedback loop, e.g. the feedback loop 710 from an output of an operational amplifier (OpAmp) 720 to one of the inputs thereof, via a transistor 730 "M₀" and a resistor divider R₁/R₂. The OpAmp 720 controls the gate voltage of the transistor 730 to regulate a current I_{L} output to a load 740 so as to make an output regulated voltage VCC_{REG} at a regulated supply node 745 equal to a set function, e.g., a set fraction controlled by resistors *R*₁ and *R*₂, of a stable reference V_{REF}. The load 740 that connects to the regulated supply node 745 of the LDO 700 can be any circuit element sinking current from the load node 745, e.g. an amplifier or a TIA.

It is typically desired that the LDO operate stably in the presence of PVT variations and maintain a suitably high and wide-band power supply rejection ratio (PSRR), i.e., the transfer function between fluctuations of the unregulated supply voltage, e.g. Vcc in FIG. 7, and fluctuations of the regulated output voltage, e.g. VCC_{REG} in FIG. 7. The greater is the PSRR, the stronger any fluctuations of the Vcc within the LDO bandwidth are attenuated in the VCC_{REG}. For example, a high PSRR may correspond to a Vcc noise attenuation of 20dB or more.

Properties of an LDO circuit related to PSRR performance may be analyzed from the poles of a loop gain frequency response of the LDO circuit. The frequency response function of the feedback loop 710 of the LDO circuit 700 has two dominant poles (i.e. the lowest-frequency poles): one at node 755 "V_{G}", the gate of the transistor 730, the other at the regulated supply node 745 "VCC_{REG}". The frequency of the pole at node 755 "V_{G}" is mostly impacted by a gate capacitance of transistor 730 "M₀", while the frequency of the pole at node 745 "VCC_{REG}" is a function of capacitance C₀. To provide a wideband PSRR, as typically desired, the pole at node 745 "VCC_{REG}" should be set to be the lowest-frequency one. This may however require a very large value for capacitance C₀ (> 100pF). In discrete LDOs the capacitance C₀ is typically implemented off-chip, but for integrated LDOs C₀ should be an on-chip capacitor, resulting in significant chip area consumption.

It may be further desired that the second pole at node 755 "V_{G}" is set to a frequency significantly higher than that of the dominant pole at node 745, so that the loop 710 does not become unstable. However, node 755 "V_{G}" in the circuit of FIG. 7 is typically a highly capacitive load, since transistor 730 "M₀" should be large enough to carry a load current of typically several mA while ensuring low-dropout operation. As a result, increasing the frequency of the second pole at node 755 is challenging, and may require either increasing the power consumption of the OpAmp 720, thus decreasing the LDO power efficiency, or increasing further the value of C₀ to move the dominant pole to lower frequency, thus further increasing the circuit area.

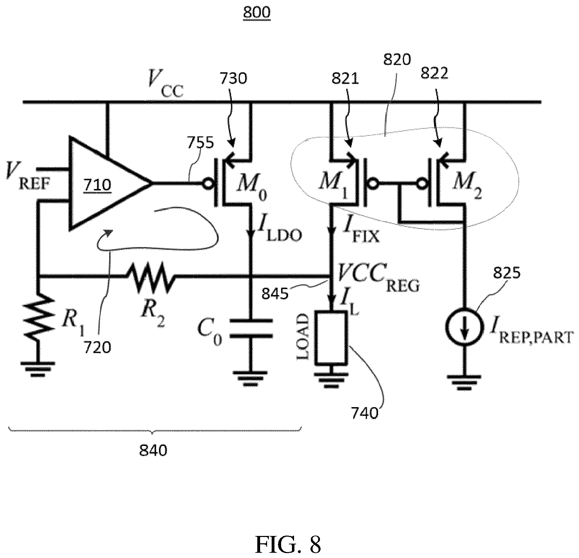

FIG. 8 shows an example circuit diagram of a voltage regulating circuit 800 according to an embodiment of the present disclosure. The voltage regulating circuit 800 includes an LDO circuit 840, which may be as described above with reference to the LDO circuit 700 of FIG. 7. The voltage regulating circuit 800 further includes a current mirror 820 connected at its output to the regulated supply node 845 and at its input to a current source 825 and configured to reduce the current through the transistor 730 "M₀" of the LDO circuit 840. The current source 825 generates a partial replica current I_{REP,PART} of an expected load current I_{Le}, and a current mirror 820 formed with a transistor pair 821 "M₁", 822 "M₂" generates a fixed output current I_{FIX} , based on the partial replica current I_{REP,PART}. The fixed output current I_{FIX}, which may be somewhat smaller than the expected load current *I*_{L}, flows into a regulated supply node 845 ("load node") to which the load 740 is attached. Only the remaining part of the load current I_{L}, i.e. the current I_{LDO} = (I_{L} - I_{FIX}), is provided to said node by the LDO feedback loop 720 through the transistor 730 "M₀". The OpAmp 720 adjusts the current I_{LDO} as needed to provide the desired value for the output voltage VCC_{REG} at the regulated supply node 845, as set by the reference voltage V_{REF} and the ratio of the resistances of resistors "R₁" and "R₂".

Sourcing a major portion, e.g. 50% or more, of the load current I_{L} from a source external to the LDO feedback loop, e.g. the current mirror 820 providing a current I_{FIX} proportional to a reference current I_{REP,PART}, allows to significantly scale down the size of the transistor 730 "M₀" compared to the LDO 700 of FIG. 7. As a result, the parasitic capacitance at node 755 "V_{G}" is reduced and the secondary pole of the LDO feedback loop 720 is pushed to a higher frequency, and the LDO stability issues are potentially mitigated. An expected, or nominal, value I_{Le} of the load current I_{L} for a particular TIA circuit may be estimated from the LDO circuit parameters and load, e.g. TIA, specifications. In an example embodiment, the replica current I_{FIX} may be set to nominally provide from about 50% to about 90% of an expected load current I_{Le} estimated for a given load 740, which allows reducing the current I_{LDO} flowing through the transistor 730 "M₀" proportionally by a factor of two or more. In an example embodiment, the replica current I_{FIX} may be about 80% of the estimated load current I_{Le}, which allows reducing the gate width of the transistor 730 "M₀" to one fifth of the gate width without the replica current I_{FIX}, since the LDO loop 710 only needs to provide about 20% of the load current I_{L}. As a result, the parasitic capacitance at node 755 "V_{G}" may be decreased by about a factor of about 5, which may be advantageous for LDO loop stability and for having a suitably high PSRR at high frequencies while relaxing requirements on the OpAmp power consumption and the C₀ footprint.

A limited precision in generating the partial replica current I_{REP,PART} may be compensated by the LDO feedback loop 720, which operates to adjust the I_{LDO} by a corresponding amount so as to a maintain the regulated output supply voltage VCC_{REG} at a target value set by the reference voltage V_{REF} and, in the embodiments of FIG. 8, by resistors "R₁" and "R₂". In the embodiment of FIG. 8, the LDO feedback loop 720 may correct for variations in the partial current replica I_{REP,PART} or for other circuit parameter variations by adjusting the current I_{LDO}, as long as the current I_{LDO} remains greater than zero Amperes (A) throughout the operation. The portion of the load current provided by the current mirror 820, i.e. the fixed current I_{FIX}, may therefore be chosen to ensure that the remaining portion of the load current I_{LDO} remains non-zero over allowed variations of the circuit parameters and operation conditions. In a typical example embodiment, variations of the load current I_{L} are expected to be within +\- 10% of a nominal value of the LDO current I_{LDO}, and a nominal value of the fixed portion of the load current, i.e. I_{FIX}, may be about 80% of an expected value of the load current I_{L}. In various embodiments the ratio of I_{FIX} to I_{L} may be adjusted up or down depending on the particular application and expected circuit and environmental parameter variations.

The circuit topology illustrated in FIG. 8 may be suitable for an on-chip LDO providing voltage supply to an analog circuit such as, e.g., an amplifier or an oscillator. In this case the load current I_{L} is typically known and may not typically experience significant drifts over time. As a result, the partial replica current I_{REP,PART} may be generated using conventional techniques for on-chip current generation.

The regulated supply circuit 800 of FIG. 8 may have a precision in the output voltage control that is suitable for controlling the TIA output common-mode voltage V_{CMOUT} in the circuit of FIGs. 5 or 6. Accordingly, the LDO circuit of FIG. 8 may be used in place of the LDO 540 shown in FIGs. 5 or 6.

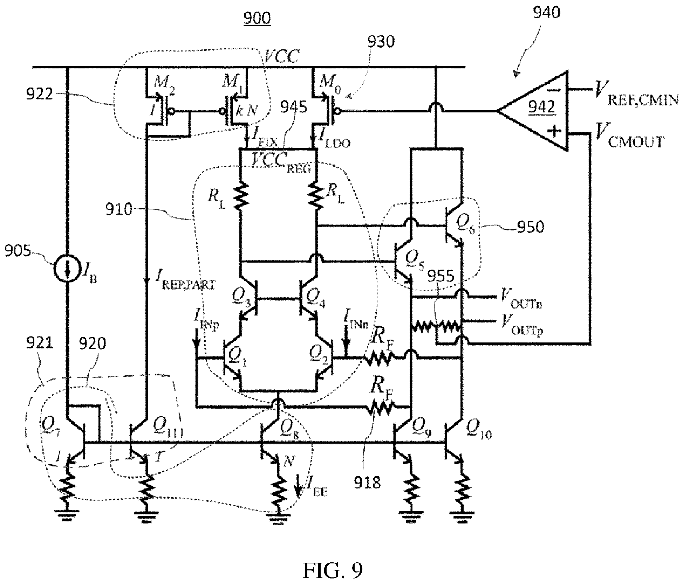

FIG. 9 illustrates an example TIA 900 using an embodiment of the LDO of FIG. 8. A current source 905 provides a reference current I_{B} to a current mirror 920 comprising transistors Q₇ and Q₈. The current mirror 920 generates a current I_{EE} ≈ *N***I*_{B}*, N* being a real number greater than 0, which biases an input stage 910 of the TIA 900. In the illustrated embodiment, the input stage 910 is a differential cascode amplifier including transistor pairs (Q₁/Q₂), (Q₃/Q₄) and load resistors R_{L}. Current mirrors 921 (transistors Q₇ and Q₁₁) and 922 (transistors Mi and M₂) are configured to source current I_{FIX} ≈ k*N*I_{B} to regulated supply node 945 VCC_{REG}. As a result, the current I_{FIX} ≈ *k* * I_{EE}, where the parameter *k* is set to e.g. 0.8 as discussed above. The remaining part, I_{LDO} , of the supply current I_{L} is provided to the TIA by an LDO circuit 940 via transistor "M₀", which is driven by a feedback loop of the LDO circuit, that operates to set the TIA output common-mode voltage V_{CMOUT} to a desired value, e.g. as described above with reference to FIG. 5. In the illustrated embodiment, the LDO circuit 940 includes an OpAmp 942 that operates to close the LDO feedback loop from an output of the OpAmp 942 to a TIA output common mode node 955, via the transistor M₀, the TIA input stage 910, and the emitter follower stage 950 ( transistor pair "Q5", "Q6"). As a result, the TIA circuit 900 in FIG. 9 may have about the same operation performance as the TIA circuit of FIG. 5, but the amount of current provided by the transistor "M₀" is substantially reduced, e.g., scaled down by a factor of (1-*k*). The gate width of the transistor "M₀" can also be correspondingly reduced, which is advantageous for the loop stability, PSRR, and power efficiency as discussed above. Since both of the currents I_{EE} (i.e. the tail current of the TIA input stage 910) and I_{FIX} (i.e. a "fixed" portion of the regulated supply current) in FIG. 9 are derived by mirroring bias current I_{B}, the I_{FIX}/I_{EE} ratio may remain approximately constant if I_{B} varies due to PVT variations.

It will be understood by one skilled in the art that various changes may be affected in the described embodiment without departing from the spirit and scope of the invention as defined by the claims. For example, although the examples illustrated in FIGs. 4, 5, 6 and 9 have a differential input to differential output configuration, other embodiments may have single input to differential output configuration, single input to single output (SISO) configuration, or a differential input to single output configuration. In the case of a TIA with a single-ended output, the circuit in FIGs. 5, 6, and 9 may be modified so that LDO OpAmp senses the TIA single-ended output DC voltage, e.g. one of the LDO OpAmp inputs is connected to the TIA output node, or a passive or active low-pass filter is included wherein the filter input is connected to the TIA output node, and the filter output is connected to one of the LDO OpAmp inputs. In another example, any of the bipolar transistors shown in FIG. 4-9 may be implemented with a FET, and vice versa. In another example, the TIA core amplifier showed in FIG. 5, 6, and 9 may use a different topology than the differential cascode with the emitter follower output stage shown. For example, the TIA might not include cascode transistors and/or might include a degeneration resistor and/or capacitor, and/or might include multiple output emitter followers, or no emitter folowers. Also, the TIA might use one or more techniques to tune the amplifier gain such as current steering, variable tail current, variable impedance shunting or inductive peaking. In another example, a different circuit arrangement with respect to the one shown in FIG. 9 may be used to generate a partial replica of the TIA current I_{REP,PART}, including but not limited to mixed-signal circuits using digital-to-analog converters and lookup tables. In some embodiments, the OpAmp in FIG. 3-9 may be replaced with an Operational Transconductance Amplifier (OTA), i.e. an OpAmp with high output impedance, with no significant impact on the circuit operation. In another embodiment, common-source P-type transistor M₀ in FIG. 4-9 may be replaced with a source-follower N-type transistor, at expense of higher minimum dropout voltage between VCC and VCC_{REG}. In some embodiments, the LDO from FIG. 8 may provide a supply voltage to all or some of the TIA gain stages. For example, in the example of FIG. 9, only the cascode amplifier (910) supply is provided by the LDO 940, while emitter followers Q₅ and Q₆ are connected to unregulated supply VCC. In other embodiments, the TIA may include additional low-frequency feedback loops, e.g. for offset correction.

It will be understood by one skilled in the art that other changes in detail may be affected in the described embodiment without departing from the spirit and scope of the invention as defined by the claims.

## Claims

1. An apparatus comprising:
a trans-impedance amplifier (TIA) (130; 240; 300; 500; 600; 900); and,
a low drop-out (LDO) circuit (540; 700; 800; 940) for providing a supply voltage to the TIA, the LDO circuit being configured to adjust the supply voltage responsive to a DC voltage at an output (534; 955) of the TIA.

2. The apparatus of claim 1 wherein the LDO circuit is configured to adjust the supply voltage to lessen variations of the DC voltage at the output of the TIA.

3. The apparatus of claims 1 or 2 wherein the LDO circuit comprises an operational amplifier (542, 942) configured to adjust the DC voltage at the output of the TIA towards a reference voltage.

4. The apparatus of claim 3 further comprising an input DC current cancellation circuit (620) configured to adjust a DC input voltage of the TIA towards the reference voltage.

5. The apparatus of claim 4 wherein the DC input voltage is a common-mode DC voltage at the input of the TIA.

6. The apparatus of claim 1 to 5, wherein the LDO circuit is configured to control a DC common-mode output voltage of the TIA.

7. The apparatus of any one of claims 1 to 5, wherein the output of the TIA is configured to provide a differential output signal, and the DC voltage at an output of the TIA is a common-mode DC voltage at the output of the TIA.

8. The apparatus of any one of claims 1 to 7 wherein the LDO circuit is configured to regulate less than 50% of a supply DC current of the TIA.

9. The apparatus of any one of claims 1 to 8 wherein the LDO circuit is configured to regulate a first portion of a supply DC current of the TIA, and wherein the apparatus further comprises a current mirror (820; 922) for adding a second portion of the supply DC current to the first portion at a supply voltage node of the TIA.

10. The apparatus of claim 9 wherein the first portion is less than 50% of the supply DC current of the TIA.

11. The apparatus of claim 9 or 10 further comprising a source of reference current (825; 921) coupled to an input of the current mirror.

12. The apparatus of any one of claims 1 to 11 wherein the LDO circuit is configured to provide a common-mode feedback from the output of the TIA to regulate the supply voltage.

13. The apparatus of any one of claims 1 to 12 comprising a coherent optical receiver (100), the coherent optical receiver comprising an optical hybrid (115) and photodiodes (120) to receive light from corresponding outputs of the optical hybrid; and wherein the coherent optical receiver comprises the TIA and the LDO circuit, first and second of the photodiodes being connected to corresponding inputs of the TIA.

14. A method comprising:
providing a supply voltage to a trans-impedance amplifier (TIA) using a low drop-out (LDO) circuit; and
configuring the LDO circuit to adjust the supply voltage responsive to a DC voltage at an output of the TIA.

15. The method of claim 14 comprising the LDO adjusting the supply voltage toward a reference voltage to lessen variations of the DC voltage at the output of the TIA.
